## Europäisches Patentamt
## European Patent Office
## Office européen des brevets

(19)

(11) Veröffentlichungsnummer : **0 012 843**
**B1**

(12)

# EUROPÄISCHE PATENTSCHRIFT

(45) Veröffentlichungstag der Patentschrift :
22.09.82

(51) Int. Cl.³ : **H 01 L 21/285**, H 01 L 29/91

(21) Anmeldenummer : 79104590.9

(22) Anmeldetag : 19.11.79

(54) **Halbleiteranordnung für Bauelemente mit einem Schottky-Kontakt.**

(30) Priorität : 20.12.78 US 971166

(43) Veröffentlichungstag der Anmeldung :
09.07.80 (Patentblatt 80/14)

(45) Bekanntmachung des Hinweises auf die Patenterteilung : 22.09.82 Patentblatt 82/38

(84) Benannte Vertragsstaaten :
DE FR GB

(56) Entgegenhaltungen :
APPLIED PHYSICS LETTERS, Band 24, Nr. 8,
15. April 1974, New York, US, J.M. SHANNON :
« Reducing the effective height of a Schottky
barrier using low-energy ion implantation »,
Seiten 369-371
IBM TECHNICAL DISCLOSURE BULLETIN,
Band 20, Nr. 8, Januar 1978, New York, US,
R. LEVI : « Reactive ion etch technique for
reducing series resistance in large-scale
integrated devices », Seiten 3 127, 3 128
IBM TECHNICAL DISCLOSURE BULLETIN,
Band 22, Nr. 3, August 1979, New York, US,
W.K. CHU et al. : « Schottky barrier diode
series resistance reduction using high energy
phosphorous ion implantation », Seiten 988, 989

(73) Patentinhaber : International Business Machines Corporation
Armonk, N.Y. 10504 (US)

(72) Erfinder : Bergeron, David Leo
21 Dufresne Drive
Winooski, Vermont 05404 (US)
Erfinder : Fleming, Daniel J.
11 Quail Run
South Burlington, Vermont (US)
Erfinder : Stephens, Geoffrey Brownell
1320 Yubinaranda Circle
Cary, North Carolina 27511 (US)

(74) Vertreter : Gaugel, Heinz, Dipl.-Ing.
Schönaicher Strasse 220
D-7030 Böblingen (DE)

### Halbleiteranordnung für Bauelemente mit einem Schottky-Kontakt

Die Erfindung betrifft eine Halbleiteranordnung gemäß dem ersten Teil des Anspruchs 1.

Eine derartige Halbleiteranordnung ist bereits in der Zeitschrift « Applied Physics Letters », Vol. 24, 1974, No. 8, Seiten 369 bis 371 beschrieben.

Beim Aufbau schneller Logikschaltkreise wird oft von Schottky-Dioden Gebrauch gemacht, um die Sättigung des Schalttransistors zu verhindern. Das Ausmaß der damit möglichen Verbesserung ist jedoch begrenzt, und zwar im Hinblick auf die nominale Höhe der sog. Barrierenspannung sowie deren Veränderung in Abhängigkeit vom jeweiligen Dotierungsgrad der Epitaxieschicht und ferner im Hinblick auf den Serienwiderstand zwischen der Schottky-Diode und dem Kollektoranschluß.

Bei typischen Anwendungen solcher Schottky-Dioden im Rahmen hochintegrierter Schaltkreise wird der Schottky-Kontakt an einer Oberflächenstelle des Halbleitersubstrats gebildet und dient als Anode dieses Bauelements. Der Schottky-Kontakt kann dabei aus Aluminium bestehen, das an der betreffenden Stelle in direktem Kontakt mit einer N-leitenden Silicium-Epitaxieschicht steht. Benachbart zu dem Schottky-Kontakt wird ein ohmscher Kontakt vorgesehen, der als Kathode der betreffenden Diode dient und aus einer Aluminiumschicht in direktem Kontakt mit einem N + Dotierungsgebiet in der Epitaxieschicht besteht. Wird die Anode relativ zur Kathode positiv vorgespannt, fließt ein Strom (in der konventionellen Richtung) vom Schottky-Kontakt durch das Material der Epitaxieschicht zum demgegenüber negativ vorgespannten ohmschen Kontakt. Mit einem solchen Stromfluß ist ein Spannungsabfall über der Schottky-Diode verbunden, der von der Dotierung der Epitaxieschicht und deren Bahnwiderstand abhängig ist. Der Spannungsabfall einer in Durchlaßrichtung betriebenen Schottky-Diode besteht demzufolge aus der Summe der Spannungsabfälle über dem eigentlichen Diodenübergang und dem Serienwiderstand im Material der Epitaxieschicht zwischen Anode und Kathode. In typischen Fällen können für eine N-leitende Silicium-Epitaxieschicht Leitfähigkeiten angenommen werden, die um bis zu 50 % nach beiden Richtungen hin schwanken. Zwischen in verschiedenen Durchläufen hergestellten integrierten Schaltkreisplättchen kommt es somit zu erheblichen Abweichungen hinsichtlich der genannten Betriebseigenschaften, so daß Schottky-Dioden aufgrund ihrer nur unzureichend vorher festlegbaren Betriebscharakteristiken bisher beim Aufbau integrierter Schaltkreise lediglich begrenzte Anwendung finden konnten.

Soweit man in integrierten Schaltkreise Zenerdioden vorgesehen hat, waren besondere Verfahrensschritte bei der Herstellung erforderlich, um eine kontrollierte Durchbruchspannung geringer Höhe, die mit den Signalpegeln in der betreffenden Schaltung vergleichbar war, zu gewährleisten.

Die Erfindung, wie sie in den Ansprüchen gekennzeichnet ist, löst die Aufgabe, hinsichtlich ihrer Betriebscharakteristik verbesserte Bauelemente mit einem Schottky-Kontak sowie ein zugehöriges Herstellungsverfahren anzugeben. Insbesondere soll die Höhe der Barrierenspannung sowie der Serienwiderstand präziser festlegbar und mit geringeren Herstellungstoleranzen ausführbar sein. Weiterhin sollen etwaige parasitäre Interaktionen dieser einen Schottky-Kontakt enthaltenden Bauelemente zu benachbarten Bauelementen reduziert werden, ohne daß die dichte Packungsmöglichkeit dieser Bauelemente dadurch beeinträchtigt wird. Schließlich sollen diese Bauelemente auch bei einem Betrieb in Sperrichtung, d.h. als Zenerdiode, im Hinblick auf die Einstellbarkeit einer gewünschten Durchbruchspannung verbessert werden.

Zusammengefaßt sieht die Erfindung vor, daß des Maximum der Gangs-Verteilung an den von der Isolierschicht bedeckten Stellen des Substrats im Substrat, näher an dessen Oberfläche, liegt, während im Bereich der Öffnung die Spitzenkonzentration entsprechend tiefer in das Substrat hineinreicht. Die Dotierungskontur im Substrat folgt dabei der Oberflächenkontur der Isolierschicht bzw. des Halbleitersubstrats. Im Bereich der Öffnung soll die Oberflächenkonzentration schließlich etwa 2 bis 10 mal größer als die Hintergrunddotierung des Substrats sein. Dadurch wird die Höhe der Barrierenspannung der herzustellenden Schottky-Diode festgelegt. Im Außenbereich der Öffnung, wo die Spitzenkonzentration entsprechend mehr zur Oberfläche des Substrats hin verschoben vorliegt, ist die Oberflächenkonzentration noch einmal mindestens 10 mal größer als im Innenbereich der Öffnung. Dadurch wird die Lebensdauer der Minoritätsträger und resultierend daraus die parasitäre PNP-Wirkung herabgesetzt. Wird neben dem Schottky-Kontakt in bekannter Weise noch ein ohmscher Kontakt vorgesehen, ist der dazwischen wirksame Serienwiderstand ebenfalls beträchtlich herabgesetzt. Auf den Betrieb in Sperrichtung wirken sich die genannten Maßnahmen ebenfalls günstig im Hinblick auf die Festlegung der Durchbruchspannung aus.

Die Erfindung wird im folgenden anhand eines Ausführungsbeispiels unter Zuhilfenahme der Zeichnungen näher erläutert.
Es zeigen :

Figur 1 einen Querschnitt durch den Aufbau einer Schottky-Diode während einer frühen Verfahrensstufe, in der die für die Kathode und Anode vorgesehenen Löcher in einer das Siliciumsubstrat bedeckenden Siliciumdioxidschicht geöffnet sind ;

Figur 2a einen vergleichbaren Querschnitt in einer späteren Verfahrensstufe, in der eine in einem Photolackmuster definierte vergrabene Dotierungsschicht in das Halbleitersubstrat implantiert wurde ;

Figur 2b in einem weiteren Querschnitt die Fertigstellung der Anordnung nach Fig. 2a durch Ausbilden der Metallisierung ;

Figuren 3 und 4 jeweilige Dotierungsprofile entlang der in Fig. 2 mit A-A' bzw. B-B' bezeichneten Schnittlinien und

Figur 5 eine Darstellung der Strom/ Spannungscharakteristik einer derartig ausgebildenen Schottky-Diode.

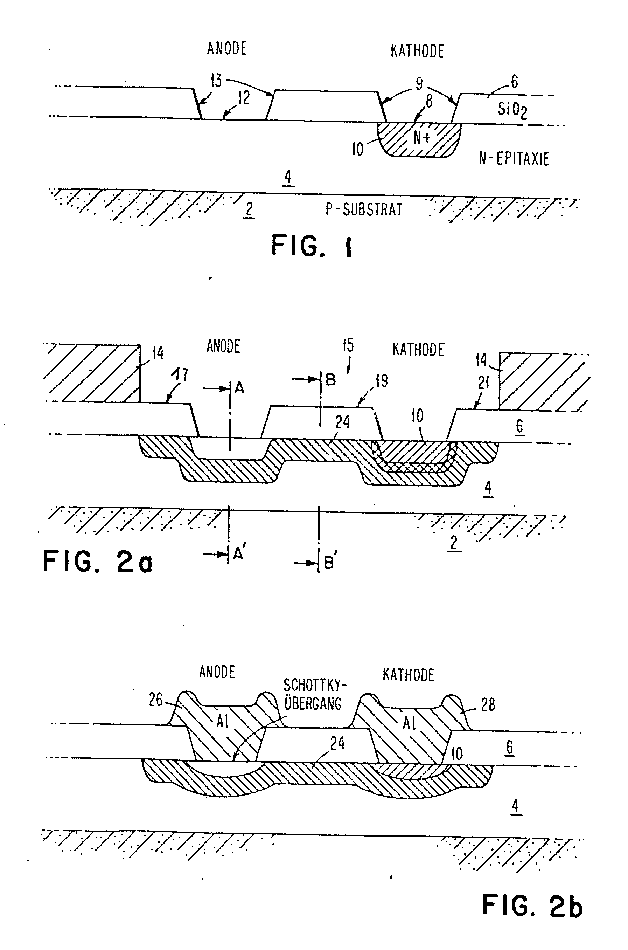

Fig. 1 zeigt einen Querschnitt während der Herstellung einer Schottky-Diode mit bestimmter Charakteristik während einer frühen Verfahrensstufe. Auf einem P-leitenden Siliciumsubstrat 2 ist eine N-leitende Epitaxieschicht 4 mit einer Dicke von ungefähr 2 μm und einer Leitfähigkeit von ungefähr 2 Ω · cm aufgebracht. Auf der Oberfläche der Epitaxieschicht 4 ist eine etwa 300 nm dicke Siliciumdioxidschicht 6 ausgebildet, in der ein mit 8 bezeichnetes Fenster an der schließlich für die Kathode der Schottky-Diode vorgesehenen Stelle geöffnet wurde. Zur Bildung des ohmschen Kontakts für den Kathodenanschluß des Bauelements ist ein mit 10 bezeichnetes N + Dotierungsgebiet durch das Fenster 8 hergestellt worden. Anschließend wurde das mit 12 bezeichnete Fenster durch die Siliciumdioxidschicht an der für die Anode vorgesehenen Stelle und benachbart zum Fenster 8 geöffnet, wobei sich ein Abstand zwischen Anode und Kathode von ungefähr 5 μm ergibt.

Fig. 2a zeigt einen Querschnitt durch den Aufbau einer solchen Schottky-Diode zu einem späteren Verfahrenszeitpunkt. Die in einem Ätzprozeß gebildeten Fenster 8 und 12 weisen geneigte Seitenflächen 9 und 13 auf. Für den Fall typischer konventioneller Ätzverfahren beträgt diese Neigung Werte von kleiner oder ungefähr gleich 45°.

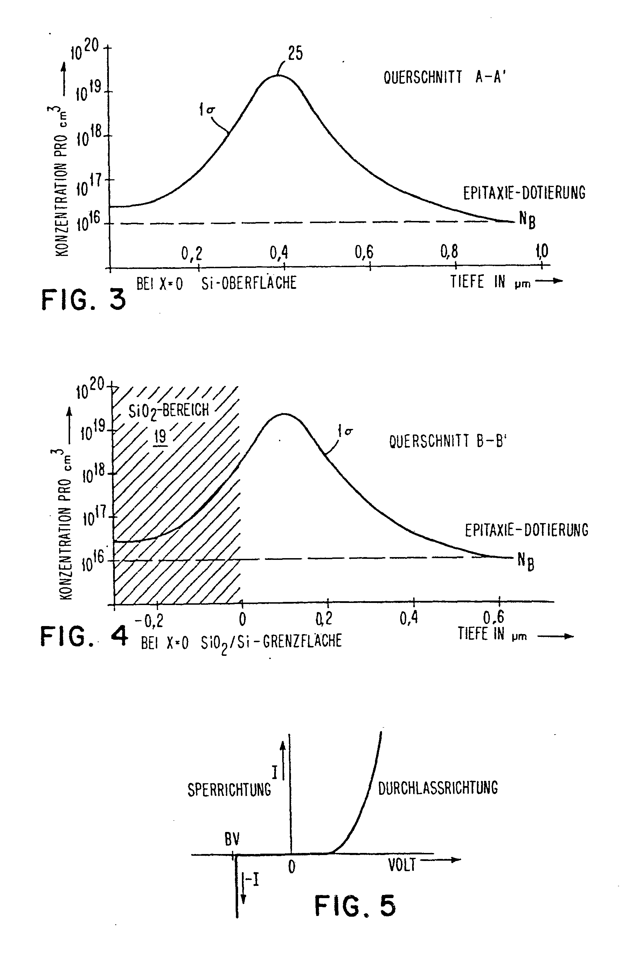

Fig. 2a läßt weiter erkennen, daß eine etwa 2 μm dicke Photolackschicht 14 mit einer den Bereich der Anode und Kathode der herzustellenden Schottky-Diode freilassenden Öffnung 15 auf der Oberfläche der Siliciumdioxidschicht 6 aufgebracht ist. Diese Photolackschicht 14 dient als Ionenimplantationsmaskierung und verhindert ein Eindringen der beschleunigten Ionen in die Epitaxieschicht 4. Anschließend erfolgt bei einer Energie von 300 keV und einer Dosis von ungefähr $10^{14}$ Atomen/cm$^2$ eine Ionenimplantation von Phosphor im Bereich des Fensters 15. Daran schließt sich für 30 Minuten ein Temper- oder Eintreibschritt bei 900 bis 1 000 °C an, um die implantierten Ladungen zu aktivieren und ggf. tiefer in den Halbleiterkörper einzutreiben. Eine Energie von ungefähr 300 keV für Phosphorionen ist dabei gerade ausreichend, daß die Ionen durch die 300 nm dicke Siliciumdioxidschicht 6 an den mit 17, 19 und 21 bezeichneten Stellen durchdringen können. Wie aus dem in Fig. 4 gezeigten Implantationsprofil deutlich wird, liegt in den mit 17, 19 und 21 bezeichneten Bereichen der Spitzenwert der Gauß-Verteilung bei oder in der Nähe der Grenzfläche zwischen der Siliciumdioxidschicht 6 und der Epitaxieschicht 4. Da im Bereich der Fenster 8 und 12 keine Siliciumdioxidschicht die Epitaxieschicht bedeckt, folgt dort das Profil der Phosphorimplantation der Oxidstufe an den Seitenflächen 9 und 13, wodurch von dem (später aufzubringenden) Kontaktmetall sowohl ein seitlicher als auch ein vertikaler Abstand eingehalten wird. Das zugehörige Konzentrationsprofil für den ionenimplantierten Bereich im Fenster 12 ist für den Querschnitt A-A' in Fig. 3 dargestellt. Es ist ersichtlich, daß die mit 25 bezeichnete Verteilungskurve am Schnittpunkt mit der Oberfläche der Epitaxieschicht 4 (X = 0) einen ausgewählt höheren Konzentrationswert als die Epitaxie-Dotierung aufweist, wodurch für die im Bereich des Fensters 12 zu bildende Schottky-Diode die Barrierenhöhe vorherbestimmbar eingestellt werden kann.

Der relative Abstand zwischen dem Spitzenwert der Verteilungskurve 25 und der Siliciumoberfläche bestimmt die Ausdehnung der Verarmungszone im Sperrbereich und damit die (Rückwärts-)Durchbruchspannung.

Die Anzahl der insgesamt implantierten Atome bestimmt den zwischen Anode und Kathode wirksamen (Serien-)Widerstand. Zusätzlich bestimmt sie auch die Rekombinationsrate der von der Schottky-Diode injizierten Minoritätsträger in dem Sinne, daß mit einer höheren Anzahl implantierter Dotieratome eine schnellere Rekombinationsrate der Minoritätsträger einhergeht. Auf diese Weise kann die parasitäre PNP-Wirkung aufgrund der Minoritätsträgerinjektion zwischen benachbarten Schottky-Dioden minimal gehalten werden.

Die in Fig. 2a mit 24 bezeichnete resultierende ionenimplantierte Schicht repräsentiert den Spitzenwert der Gauß-Verteilung der implantierten Ionen zuzüglich bzw. abzüglich einer Standardabweichung entsprechend den Darstellungen in den Fig. 3 und 4.

In Fig. 2b ist die verfahrensmäßige Fertigstellung einer solchen Schottky-Diode dargestellt, indem im Bereich der Fenster 12 bzw. 8 eine Aluminiumschicht zur Ausbildung der Kontakte 26 bzw. 28 aufgebracht ist. Der Kontakt 26 bildet einen Schottky-Übergang zur N Epitaxieschicht 4 und damit die Anode der Schottky-Diode. Der Kontakt 28 stellt einen direkten Kontakt zum N + Dotierungsgebiet 10 her und bildet somit einen ohmschen Kontakt, der die Kathode der Schottky-Diode darstellt. Das ionenimplantierte Gebiet 24 bewirkt im Bereich des früher mit 12 bezeichneten Fensters (an der Anode) eine Absenkung der Barrierenspannung der Schottky-Diode, in dem es einen kontrollierten höheren Dotierungspegel in der in Fig. 3 gezeigten Weise an der Grenzfläche vorsieht. Darüber hinaus bewirkt die ionenimplantierte Schicht 24 einen verringerten Serienwiderstand zwischen Anode und Kathode, da der von der Anode zur Kathode fließende Strom statt durch das Halbleitermaterial der Epitaxieschicht 4 mit höherem Widerstandswert nunmehr durch das demgegenüber niederohmigere implantierte Gebiet 24 fließen kann. Darüber hinaus kann die resultierende Charakteristik der Schottky-Diode mit engeren Herstellungstoleranzen für die Barrierenspannung und den Serienwiderstand festgelegt werden, weil bezüglich des ionenimplantierten Gebiets im Vergleich zur Epitaxieschicht 4 eine bessere Kontrolle der Dotierungskonzentration möglich ist. Unter bestimmten Bedingungen werden schließlich vom Schottky-Übergang (Anode) Löcher erzeugt und in die N-leitendes Epitaxieschicht 4 geraten. In bisher bekannten Strukturen können solche Löcher vom Anodenbereich wegdiffundieren und zu unerwünschten parasitären Wirkungen zwischen benachbarten Schottky-Dioden oder benachbarten P-leitenden Dotierungsgebieten führen. Bei dem in Fig. 2b gezeigten Aufbau wird diese Wirkung infolge der höheren Rekombinationsrate aufgrund des N dotierten Implantationsgebiets 24 minimal gehalten.

Anhand von Fig. 5 sollen die Betriebseigenschaften einer derartigen Schottky-Diode illustriert werden. Gegenüber bekannten Schottky-Dioden wird wegen des verringerten Serien-Widerstandes sowie der reduzierten Barrierenspannung der Spannungsabfall in Durchlaßrichtung wesentlich reduziert. Das erfolgt, wie gesagt, durch die mittels Ionenimplantation erhöhte Dotierung des mit 24 bezeichneten Gebietes. Die jeweilige Einstellung des Spannungsabfalls einer solchen Diode in Durchlaßrichtung bestimmt sich durch den an der Metall/Silicium-Grenzfläche vorliegenden Konzentrationswert, der für die Implantation geltenden Verteilungskurve (Fig. 3). In gleicher Weise wird durch die mittels Implantation entsprechend der angegebenen Verteilung durch Beeinflussung des inneren elektrischen Feldes am Metall/Silicium-Übergang die (ursprüngliche) Barrierenspannung abgesenkt und so die Höhe der für die betreffende Schottky-Diode maßgeblichen Barrierenspannung eingestellt.

Zusätzlich dazu wird auch mit dem in Fig. 2b gezeigten Aufbau einer Schottky-Diode eine verbesserte Durchbruchscharakteristik beim Betrieb in Sperrichtung erzielbar. Im einzelnen wird mit dem angegebenen strukturellen Aufbau eine einstellbare Zenerdiode gebildet. Unter Bezugnahme auf Fig. 3 soll erläutert werden, wie die verbesserte, einstellbare Zenerdioden-Charakteristik beim Betrieb in Sperrichtung erzielt werden kann. Wenn in der in Fig. 2b dargestellten Struktur kein ionenimplantiertes Gebiet 24 vorhanden wäre, würde beim Betrieb der Schottky-Diode in Sperrichtung eine Verarmungszone den Schottky-Übergang umgeben und sich in das Material der Epitaxieschicht 4 ausweiten. Im Gegensatz dazu ist bei dem in Fig. 2b gezeigten Aufbau infolge des N-leitenden implantierten Gebiets 24 die N-leitende Dotierungskonzentration in einer Tiefe von ungefähr 0,4 µm unterhalb der Oberfläche der Epitaxieschicht um etwa drei Größenordnungen angehoben. Unter diesen Umständen wird die Ausweitung der den Schottky-Übergang umgebenden Verarmungszone durch das implantierte Gebiet 24 verhindert, wodurch der Spitzenwert der elektrischen Feldstärke bei einer gegebenen Spannung erhölt wird. Als Folge davon wird für eine solche Diode der Avalanche-Durchbruch bei einer niedrigeren Spannung als sonst erreicht. Somit wird durch eine genaue Wahl der Implantationsenergie, welche den Spitzenwert der Gauß-Verteilung im ionenimplantierten Bereich in der in Fig. 3 gezeigten Weise anordnet, die resultierende Avalanche-Durchbruchspannung beim Betrieb in Sperrichtung (Zenerdiode) festgelegt. Mit anderen Worten läßt sich durch die jeweilige Wahl der Beschleunigungsspannung bei der Implantation und zusätzlich durch geeignete Einstellung der Dotierungsdosis oder -konzentration im implantierten Gebiet 24 die Zener-Durchbruchspannung für die resultierende Schottky-Diode festlegen. Als wesentlicher Vorteil einer solchen Struktur mit der in Fig. 5 gezeigten Charakteristik ist es anzusehen, daß die Zener-Durchbruchspannung wesentlich kleiner als bisher üblich gemacht werden kann, womit auch die im Zusammenhang mit hochintegrierten Schaltkreisen auftretenden kleinen Signalspannungspegel erfaßt werden können, ohne daß dazu ein übermäßig komplex ausgestattetes Herstellungsverfahren erforderlich wäre.

Festzuhalten ist, daß auf die beschriebene Weise Schottky-Dioden mit mehreren, jeweils spezifischen Bauelementcharakteristiken erzielbar sind. Durch die jeweilige Wahl der Implantationsdosis, Energie, Temperzeit und -temperatur sowie Oxiddicke im Bereich 19 werden die Oberflächenkonzentration und damit die Höhe der Barrierenspannung, die insgesamten Dotierungspegel und damit der Serienwiderstand sowie die Minoritätsträger-Lebensdauer, und schließlich der Abstand zwischen der Metall-Grenzfläche und der Spitzenkonzentration im implantierten Bereich und daraus folgend die Ausweitung des Verarmungsgebiets sowie die resultierende Durchbruchspannung festgelegt. Es ist ersichtlich, daß mit einem einzigen Verfahrensschritt zur Ausbildung des implantierten Gebiets 24 der Design von Schottky-Dioden mit bestimmten Bauelementcharakteristiken möglich ist, die jeweils abhängig sind von der Implantationsenergie der zugehörigen Dosierung sowie der Oxiddicke.

Schließlich ist festzuhalten, daß das implantierte Gebiet 24 in seiner räumlichen Ausdehnung der Oberflächenkontur des Oxidbereichs 19 folgt und somit der Spitzenwert des Dotierungsprofils hinsichtlich seiner Ausrichtung zum Kontaktloch der Schottky-Diode selbstausrichtend ist. Somit ergibt sich neben einer verbesserten Betriebscharakteristik auch eine verbesserte Packungsdichte.

## Ansprüche

1. Halbleiteranordnung für Bauelemente mit einem hinsichtlich seiner Charakteristik einstellbaren Schottky-Kontakt, z.B. für eine Schottky-Diodenstruktur, mit einer auf einem Halbleitersubstrat (2) angeordneten Epitaxieschicht (4) eines ersten Leitfähigkeitstyps (z.B. N) und einer ersten Dotierkonzentration, auf welcher sich eine Isolierschicht (6) befindet, in der an der für den Schottky-Kontakt vorgesehenen Stelle eine Öffnung (12) ausgebildet ist, die von trichterförmig geneigten Seitenflächen (13) der Isolierschicht (6) eingerahmt und mit einem zusammen mit dem Material der Epitaxieschicht einen gleichrichtenden Übergang ergebenden Metallkontakt belegt ist, und mit einem implantierten Dotierungsgebiet (24) im Bereich der Öffnung in der Epitaxieschicht dessen Konzentrationsprofil senkrecht zur Substratoberfläche im wesentlichen einer Gauß-Verteilung folgt, deren Maximum im Innenbereich der Öffnung einen durch die gewählte Höhe der Barrierenspannung vorgegebenen Abstand von der Oberfläche der Epitaxieschicht aufweist, dadurch gekennzeichnet, daß das implantierte Dotierungsgebiet (24) im Innenbereich der Öffnung (12) an der Oberfläche der Epitaxieschicht (4) eine zweite Dotierungskonzentration aufweist, die 2- bis 10-fach höher ist als die erste Dotierungskonzentration in der Epitaxieschicht außerhalb des implantierten Dotierungsgebietes, und in dem an die Öffnung sich anschließenden Außenbereich an der Grenzfläche zwischen der Isolierschicht (6) und der Epitaxieschicht (4) mindestens eine 10-fach höhere dritte Dotierungskonzentration verglichen mit der zweiten Dotierungskonzentration, und daß der Abstand des Maximums der Gauß-Verteilung von der Oberfläche der Epitaxieschicht der jeweiligen Oberflächenstruktur der Isolierschicht folgend sich vom Innen- zum Außenbereich der Öffnung in der Weise verringert, daß das Maximum im Außenbereich in der Nähe der Grenzfläche aber in der Epitaxieschicht liegt.

2. Halbleiteranordnung nach Anspruch 1, dadurch gekennzeichnet, daß im Außenbereich (19, 21) der ersten Öffnung (12) in der Isolierschicht (6) eine zweite Öffnung (8) vorgesehen ist, die mit einem ohmschen Kontakt (28) belegt ist für einen elektrischen Anschluß des implantierten Dotierungsgebiets (24).

3. Halbleiteranordnung nach Anspruch 1 oder 2, gekennzeichnet durch einen Neigungswinkel der Seitenflächen (z.B. 13) der Öffnungen (z.B. 12) in der Isolierschicht (6) von kleiner 45°.

4. Halbleiteranordnung nach einem der vorhergehenden Ansprüche, dadurch gekennzeichnet, daß die dritte Dotierungskonzentration mindestens $10^{18}$ Atome/cm³ oder größer beträgt.

5. Halbleiteranordnung nach einem der vorhergehenden Ansprüche, dadurch gekennzeichnet, daß der den Schottky-Übergang bildende Metallkontakt (26) aus einem Material aus der Gruppe enthaltend Aluminium, Silicium, oder Titan-Wolfram-Legierungen, Platin, Tantal, Chrom und Molybdän besteht.

6. Halbleiteranordnung nach einem der vorhergehenden Ansprüche, dadurch gekennzeichnet, daß durch sie der Kollektor einer Bipolartransistorstruktur gebildet ist.

7. Halbleiteranordnung nach einem der vorhergehenden Ansprüche, dadurch gekennzeichnet, daß durch sie bei einem Betrieb in Sperrichtung eine Schottky-Zenerdiode gebildet ist, wobei der Wert der zweiten Dotierungskonzentration abhängig von der jeweiligen Durchbruchspannung in Sperrichtung gewählt ist.

8. Verfahren zur Herstellung einer Halbleiteranordnung nach einem der Ansprüche 2 bis 7 bei dem nacheinander

a) auf einem mit einer Epitaxieschicht (4) versehenen Halbleitersubstrat (2) eines ersten Leitfähigkeitstyps eine Isolierschicht (6) aufgebracht wird,

b) in der Isolierschicht (6) an der für den Schottky-Kontakt (26) vorgesehenen Stelle eine erste Öffnung (12) mit trichterförmig geneigten Isolierschichtseitenflächen (13) ausgebildet wird,

c) in der Isolierschicht an der für den ohmschen Kontakt (28) vorgesehenen Stelle eine zweite Öffnung (8) ausgebildet wird,

d) durch die zweite Öffnung (8) in die Epitaxieschicht (4) ein verglichen mit der dritten Dotierungskonzentration höher dotiertes Gebiet (10) vom ersten Leitfähigkeitstyp eingebracht wird,

e) eine Ionenimplantationsmaske (14) mit einer die erste und zweite Öffnung freilassenden Öffnung (15) aufgebracht wird,

f) die Ionenimplantation durchgeführt wird,

g) die Kontakte (26, 28) im Bereich der ersten und zweiten Öffnung ausgebildet werden.

## Claims

1. A semiconductor arrangement for devices having a Schottky contact with controlled characteristics, e.g., for a Schottky diode structure, comprising an epitaxial layer (4) of a first conductivity type (e.g., N) and a first doping concentration overlying a semiconductor substrate (2), the epitaxial layer (4) being followed by an insulating layer (6) having in the area provided for the Schottky contact an opening (12) which is surrounded by inclined sidewalls (13) of the insulating layer (6) and which is occupied by a metallic contact forming a rectifying junction with the material of the epitaxial layer, and with an implanted doping region (24) in the region of the opening in the epitaxial layer, whose concentration profile perpendicular to the substrate surface has a substantially Gaussian distribution, whose maximum value in the inside region of the opening has a predetermined distance from the surface of the epitaxial layer, which is a function of the selected value of the barrier voltage, characterized in that the implanted doping region (24) in the inside region of the opening (12) on the surface of the epitaxial layer (4) has a second doping concentration which is 2 to 10 times greater than the first doping concentration in the epitaxial layer outside the implanted doping region, and wherein in the outside region adjacent to the opening at the interface between insulating layer (6) and epitaxial layer (4) there is an at least 10 times higher third doping concentration compared to the second doping concentration, and that the distance of the maximum value of the Gaussian distribution from the surface of the epitaxial layer of the respective surface structure following the insulating layer decreases from the inside to the outside region of the opening in such a manner that the maximum value in the outside region is close to the interface but inside the epitaxial layer.

2. The semiconductor arrangement according to claim 1, characterized in that in the outside region (19, 21) of the first opening (12) in the insulating layer (6) there is a second opening (8) which is occupied by an ohmic contact (28) for electrically connecting the implanted doping region (24).

3. The semiconductor arrangement according to claim 1 or 2, characterized by an angle of inclination of the sidewalls (e.g., 13) of the openings (e.g., 12) in the insulating layer (6) of less than 45°.

4. The semiconductor arrangement according to any one of the preceding claims, characterized in that the third doping concentration is at least $10^{16}$ atoms/cm$^3$ or greater.

5. The semiconductor arrangement according to any one of the preceding claims, characterized in that the metallic contact (26) forming the Schottky junction is composed of a material of the group consisting of aluminium, silicon or titanium tungsten alloys, platinum, tantalum, chromium, and molybdenum.

6. The semiconductor arrangement according to any one of the preceding claims, characterized in that it forms the collector of a bipolar transistor structure.

7. The semiconductor arrangement according to any one of the preceding claims, characterized in that during the operation in the reverse direction, it forms a Schottky zener diode, with the value of the second doping concentration being selected as a function of the respective breakdown voltage in the reverse direction.

8. A process for producing a semiconductor arrangement according to any one of the claims 2 to 7, comprising the steps of

a) applying an insulating layer (6) to a first conductivity type semiconductor substrate (2) provided with an epitaxial layer (4),

b) forming in the insulating layer (6) in the area provided for the Schottky contact (26), a first opening (12) with inclined insulating layer sidewalls (13),

c) forming in the insulating layer in the area provided for the ohmic contact (28), a second opening (8),

d) introducing into the epitaxial layer (4) through the second opening (8) a first conductivity type region (10) which is more highly doped than the third doping concentration,

e) applying an ion implantation mask (14) with a window region (15) for the first and the second opening,

f) implanting the ions, and

g) forming the contacts (26, 28) in the region of the first and the second opening.

## Revendications

1. Arrangement semi-conducteur pour des dispositifs à contact de Schottky dont les caractéristiques sont contrôlées, par exemple pour une structure de diode du type de Schottky comportant : une couche épitaxiale (4) déposée sur un substrat semi-conducteur (2), d'un premier type de conductivité (par exemple N) et d'une première concentration de dopage ; une couche isolante (6) est déposée sur cette couche, dans laquelle, à l'emplacement prévu pour le contact de Schottky, une ouverture (12) est formée, encadrée par des surfaces latérales (13) de la couche isolante (6), inclinées à la façon d'un entonnoir et qui comporte un contact métallique qui forme une jonction redresseuse avec le matériau de la couche épitaxiale ; une région de dopage implantée (24) dans la région de l'ouverture dans la couche épitaxiale, dont le profil de concentration, pris perpendiculairement à la surface de substrat, suit essentiellement une répartition de Gauss, dont le maximum à l'intérieur de l'ouverture se situe à une distance de la surface de la couche épitaxiale qui est fonction de la valeur de la tension de barrière, arrangement semi-conducteur, caractérisé en ce que la région de dopage implantée (24) à l'intérieur de l'ouverture (12), comporte à la surface de la couche épitaxiale (4) une seconde concentration de dopage, qui est de deux à dix fois supérieure à ladite première concentration de dopage dans la couche épitaxiale à l'extérieur de la région de dopage implantée et que dans la région extérieure adjacente à l'ouverture, à l'interface entre la couche isolante (6) et la couche épitaxiale (4), elle comporte une troisième concentration de dopage dix fois supérieure à ladite seconde concentration de dopage ; et enfin en ce que la distance du maximum de la répartition de Gauss, à partir de la surface de la couche épitaxiale, suivant la structure de surface respective de la couche isolante, diminue de l'intérieur vers l'extérieur de l'ouverture de telle sorte que le maximum dans la région extérieure est situé, à proximité de l'interface, mais dans la couche épitaxiale.

2. Arrangement semi-conducteur selon la revendication 1, caractérisé en ce que dans la région extérieure (19, 21) de la première ouverture (12) dans la couche isolante (6) il est prévu une seconde ouverture (8) occupée par un contact ohmique (28) pour une connexion électrique de la région de dopage implantée (24).

3. Arrangement semi-conducteur selon la revendication 1 ou 2, caractérisé par un angle d'inclinaison des surfaces latérales (par exemple 13) des ouvertures (par exemple 12) dans la couche isolante (6) qui est inférieur à 45°.

4. Arrangement semi-conducteur selon l'une des revendications précédentes, caractérisé en ce que la troisième concentration de dopage est au moins égale ou plus grande que $10^{18}$ atomes/cm³.

5. Arrangement semi-conducteur selon l'une des revendications précédentes, caractérisé en ce que le contact métallique (26) formant la jonction de Schottky est réalisé à partir d'un matériau choisi dans le groupe comprenant les alliages aluminium-silicium, les alliages titane-tungstène, le platine, le tantale, le chrome et le molybdène.

6. Arrangement semi-conducteur selon l'une des revendications précédentes, caractérisé en ce qu'il forme le collecteur d'une structure de transistor bipolaire.

7. Arrangement semi-conducteur selon l'une des revendications précédentes, caractérisé en ce qu'il forme, en fonctionnement inverse, une diode Zener du type Schottky, la valeur de la seconde concentration de dopage étant une fonction de la tension de claquage en inverse.

8. Procédé pour fabriquer un arrangement semi-conducteur selon l'une des revendications 2 à 7, dans lequel, dans des étapes successives :

a) on dépose une couche isolante (6) sur un substrat semi-conducteur (2) d'un premier type de conductivité recouvert par une couche épitaxiale (4),

b) on forme dans la couche isolante (6), à l'emplacement prévu pour le contact de Schottky (26), une première ouverture (12) ayant des surfaces latérales isolantes (13) inclinées à la façon d'un entonnoir,

c) on forme dans la couche isolante, à l'emplacement prévu pour le contact ohmique (28), une seconde ouverture (8),

d) on diffuse à travers la seconde ouverture (8) dans la couche épitaxiale (4) une région (10) du premier type de conductivité d'un niveau de dopage plus élevé que la troisième concentration de dopage,

e) on dépose un masque d'implantation ionique (14) comportant une ouverture (15) exposant les première et seconde ouvertures,

f) on effectue l'implantation ionique, et

g) on forme les contacts (26, 28) dans la région des première et seconde ouvertures.

ANODE    KATHODE

13    9    6

12    8    $SiO_2$

10    N+

N-EPITAXIE

4

2    P-SUBSTRAT

**FIG. 1**

14    ANODE    15    KATHODE    14

17    A    B    19    21

24    10    6

4

A'    B'    2

**FIG. 2a**

ANODE    SCHOTTKY-    KATHODE
ÜBERGANG

26    28

Al    Al

24    10    6

4

**FIG. 2b**

FIG. 3

FIG. 4

FIG. 5